(19) Europäisches Patentamt
European Patent Office
Office européen des brevets

(11) **EP 1 196 945 B1**

(12) **EUROPÄISCHE PATENTSCHRIFT**

(45) Veröffentlichungstag und Bekanntmachung des Hinweises auf die Patenterteilung:
**24.06.2009 Patentblatt 2009/26**

(21) Anmeldenummer: **00954332.3**

(22) Anmeldetag: **13.07.2000**

(51) Int Cl.:
*H01L 21/223* (2006.01)   *H01L 21/331* (2006.01)

(86) Internationale Anmeldenummer:
**PCT/DE2000/002293**

(87) Internationale Veröffentlichungsnummer:
**WO 2001/006551 (25.01.2001 Gazette 2001/04)**

(54) **VERFAHREN ZUR HERSTELLUNG ZWEIER UNTERSCHIEDLICH DOTIERTER BENACHBARTER GEBIETE IN EINEM INTEGRIERTEN HALBLEITER**

METHOD FOR PRODUCING TWO DIFFERENTLY DOPED ADJACENT REGIONS IN AN INTEGRATED SEMICONDUCTOR

PROCEDE DE PRODUCTION DE DEUX ZONES ADJACENTES A DOPAGE DIFFERENT DANS UN SEMI-CONDUCTEUR INTEGRE

(84) Benannte Vertragsstaaten:
**DE FR GB IT NL**

(30) Priorität: **20.07.1999 DE 19933959**

(43) Veröffentlichungstag der Anmeldung:
**17.04.2002 Patentblatt 2002/16**

(73) Patentinhaber: **Infineon Technologies AG 81669 München (DE)**

(72) Erfinder: **BÖCK, Josef D-80807 München (DE)**

(74) Vertreter: **Ginzel, Christian et al Zimmermann & Partner Postfach 330 920 80069 München (DE)**

(56) Entgegenhaltungen:
**US-A- 3 974 516     US-A- 5 213 988 US-A- 5 747 374**

• **PATENT ABSTRACTS OF JAPAN vol. 008, no. 088 (E-240), 21. April 1984 (1984-04-21) & JP 59 006574 A (MATSUSHITA DENSHI KOGYO KK), 13. Januar 1984 (1984-01-13)**
• **PATENT ABSTRACTS OF JAPAN vol. 007, no. 276 (E-215), 9. Dezember 1983 (1983-12-09) & JP 58 155764 A (MATSUSHITA DENSHI KOGYO KK), 16. September 1983 (1983-09-16)**

**Beschreibung**

Verfahren zur Herstellung zweier unterschiedlich dotierter benachbarter Gebiete in einem integrierten Halbleiter.

Die vorliegende Erfindung betrifft ein Verfahren zur Herstellung zweier benachbarter Gebiete eines vorbestimmten Bereichs in einem integrierten Halbleiter mit unterschiedlicher Dotierung, einen nach dem erfindungsgemäßen Verfahren herstellbaren integrierten Transistor und die Verwendung des erfindungsgemäßen Verfahrens zur Herstellung eines integrierten Transistors.

Bei der Herstellung integrierter Halbleiterstrukturen ergibt sich häufig das Problem, daß unmittelbar benachbarte Gebiete unterschiedlich dotiert werden müssen. Das Problem solcher unterschiedlicher Dotierungen und im Stand der Technik bekannte Lösungen sollen im folgenden an Hand eines konkreten Beispiels der Verwendung bei einem integrierten Transistor diskutiert werden. Es versteht sich jedoch, daß das erfindungsgemäße Verfahren auch auf andere Anwendungsgebiete bei der Halbleiterproduktion anwendbar ist und nicht auf die Verwendung bei der Herstellung von integrierten Transistoren beschränkt sein soll.

Ein im Stand der Technik bekannter bipolarer Transistor in einem integrierten Halbleiter umfasst einen eigentlichen, aktiven Transistor. Dieser besteht hierbei aus drei benachbarten, unterschiedlich dotierten Bereichen von Halbleitern, dem Emitterbereich, dem Basisbereich sowie dem Kollektorbereich. Je nach Dotierung wird zwischen pnp-Transistoren und npn-Transistoren unterschieden, wobei die Abfolge der Buchstaben die Abfolge der Dotierung im Emitter-, Basis- und Kollektorbereich kennzeichnet.

Ein in einem integrierten Schaltkreis angeordneter Transistor hat darüber hinaus noch ihn umgebende weitere Hilfsstrukturen, die einerseits der Isolierung der Potentiale, anderseits der Ableitung der Ströme vom aktiven Transistorbereich dienen. Der Emitterbereich wird über einen Emitterkontakt, üblicherweise aus Polysilizium, mit einer Emitterleiterbahn, beispielsweise aus Aluminium, verbunden. Der Basisbereich wird über einen Basiskontakt mit einer Basisleiterbahn verbunden. Der Kollektorbereich schließlich wird über einen sogenannten "buried layer", der sich unterhalb der anderen Strukturen befindet, und eine Zwischenschicht sowie einen Kollektorkontakt mit einer Kollektorleiterbahn verbunden. Verschiedene Siliziumoxidisolationsschichten sowie Spacerisolatoren dienen der elektrischen Trennung der verschiedenen elektrisch leitenden Strukturen.

Der sogenannte Basisbahnwiderstand, welcher der Widerstand zwischen der Basis und der Basisleiterbahn ist, ist bei Bipolartransistoren neben der Transitfrequenz und der Basiskollektorkapazität der entscheidende Transistorparameter, der wichtige Kenngrößen des Transistors wie seine maximale Oszillationsfrequenz, seinen Gain, seine minimale Rauschzahl, seine Gatterverzögerungszeiten, etc., bestimmt. So gilt beispielsweise

$$f_{max} \approx \sqrt{\frac{f_T}{8\pi \cdot R_B \cdot C_{BC}}} \qquad\qquad (1)$$

wobei

$f_{max}$:   maximale Oszillationsfrequenz
$f_T$:   Transitfrequenz
$R_B$:   Basiswiderstand
$C_{BC}$:   Basiskollektor-Kapazität

oder

$$F_{min} \approx 1 + \frac{1}{\beta} + \frac{f}{f_T}\sqrt{\frac{2 \cdot I_C}{V_T}R_B\left(1 + \frac{f_T^2}{\beta \cdot f^2}\right) + \frac{f_T^2}{\beta \cdot f^2}} \qquad\qquad (2),$$

wobei

$F_{min}$:   minimale Rauschzahl
$\beta$:   Stromverstärkung
$f$:   Frequenz

$f_T$:      Transitfrequenz

$I_C$:      Kollektorstrom

$V_T$:      thermische Spannung

$R_B$:      Basiswiderstand

sind.

Bei selbstjustierten Siliziumbipolartransistoren setzt sich der Basiswiderstand im wesentlichen aus drei Anteilen zusammen, die im folgenden als $R_{B,i}$, $R_{B,e}$ und $R_{B,I}$ bezeichnet werden. Der innere Anteil $R_{B,i}$ entsteht durch den Widerstand des Basisgebiets im aktiven Transistor unterhalb des Emitterbereichs. Der externe Anteil $R_{B,e}$ beschreibt den Widerstand der Polysiliziumbahn, die den Basiskontakt bildet. $R_{B,I}$ stellt den Basiswiderstand dar, der durch eine niedrig dotierte Zone unter der selbstjustierten Emitterbasisisolation, dem Spacerisolator, am aktiven Transistor entsteht. Dieses Gebiet wird in der Literatur allgemein als Linkgebiet bezeichnet.

Um den Basiswiderstand zu verringern, können Optimierungen an allen drei Bereichen vorgenommen werden.

Durch die fortschreitende laterale Skalierung der Bauteile kann der interne Anteil $R_{B,i}$ immer mehr verringert werden. Der externe Anteil $R_{B,e}$ läßt sich ebenfalls durch laterale Skalierung oder durch die Verwendung niederohmiger Materialien (zum Beispiel Silizide) verkleinern. Somit gewinnt der Link-Anteil für den Gesamtbasiswiderstand immer zunehmend an Bedeutung. Um den Widerstand im Linkgebiet zu verringern, wäre es sinnvoll, die Leitfähigkeit des Siliziums unter dem Spacer durch eine gezielte zusätzliche Basisdotierung zu erhöhen.

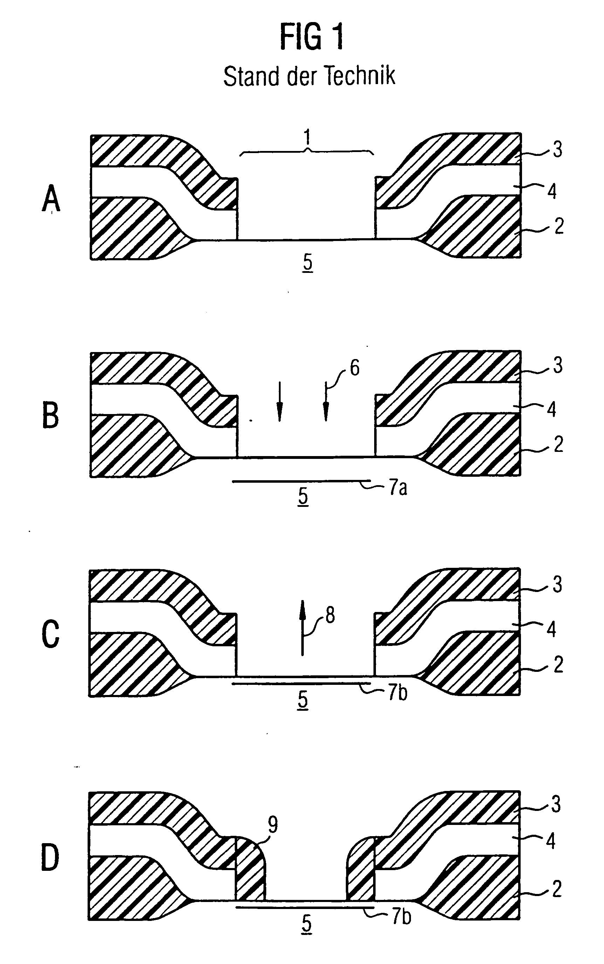

Figur 1 zeigt den schematischen Prozeßfluß zur Bildung der aktiven Basis und des Linkgebietes bei im Stand der Technik bekannten Produktionstechnologien. Hierbei zeigt Figur 1A den Ausgangszustand des Halbleiterrohlings vor der Basisdotierung. Das Emitterfenster 1, das im Bereich des späteren aktiven Transistors angelegt wird, wird üblicherweise mit Hilfe einer Trockenätztechnik strukturiert. Neben dem Emitterfenster sind weitere Strukturen des Halbleiters dargestellt, nämlich zwei Isolationsschichten 2 und 3 sowie eine Polysiliziumschicht 4, welche die Polysiliziumbahn als externen Anteil der Basis des zu bildenden Transistors darstellt. Die Isolationsschicht 2 kann beispielsweise mit Hilfe der LOCOS-Technologie, die Isolationsschicht 3 mit Hilfe der TEOS-Technologie aufgebracht werden.

Es erfolgt nunmehr eine Dotierstoffimplantation des gewünschten Dotierstoffes, wie in Figur 1B durch die mit Bezugszeichen 6 gekennzeichneten Pfeile dargestellt ist. Dies führt zu einer Basisdotierung 7a, die sich im Untergrund des zu bildenden Transistors 5 befindet. Die gewählte Darstellungsform eines Striches kennzeichnet hierbei ein bestimmtes Grenzlevel an Basisdotierung. Oberhalb der Linie 7a ist die durch Implantation erfolgte Dotierung höher als ein bestimmtes Grenzlevel, also eine bestimmte Grenzkonzentration innerhalb des Siliziums. Unterhalb der Linie 7a liegt sie niedriger. Bei geeigneter Wahl des Grenzlevels kann man also in erster Näherung sagen, daß die Dotierung beispielsweise bis zur Linie 7a hinreicht.

Der folgende Schritt bei der Herstellung eines im Stand der Technik bekannten Transistors ist das Ausheilen von bei der Dotierstoffimplantation aufgetretenen Implantationsschäden. Dieses Ausheilen erfolgt üblicherweise durch einen Temperungsschritt, bei dem der gesamte Wafer einer definierten Temperaturerhöhung unterworfen wird. Dabei erfolgt eine Verringerung der Basisdotierung durch eine Dotierstoffausdiffusion, wie sie in Figur 1C durch den Pfeil 8 dargestellt ist. Die Verringerung der Basisdotierung zeigt sich in einer Verschiebung des Grenzlevels der Basisdotierung zur Oberfläche hin, wie durch die Linie 7b dargestellt wird.

Im Anschluß wird ein Spacer 9 auf das im Emitterfenster freiliegende Silizium abgeschieden, welcher die darunter liegenden Gebiete des Basisbereichs als Linkgebiete definiert. Die Dotierungen im aktiven Basisgebiet und im Linkgebiet unter dem Spacer sind bei diesem vorbekannten Verfahren somit identisch.

Im Stand der Technik sind bereits verschiedene Verfahren zur Erhöhung der gezielten Basisdotierung unter dem Spacer vorgeschlagen worden, die sich im wesentlichen in zwei Gruppen einteilen lassen, zum einen in Verfahren mit einer zusätzlichen lokalen Implantation im Linkbereich, zum anderen in Verfahren zur lokalen Erhöhung der Dotierung im Spacerbereich durch Diffusion aus hochdotierten Hilfsschichten.

Bei der ersten Variante wird mit üblichen Verfahren der Linkbereich gezielt implantiert, indem Dotierstoffe auf dem Linkbereich abgeschieden werden.

Bei diesem Verfahren muß der aktive Basisbereich abgedeckt werden. Eine Maskierung mit Lack und Photolithographie ist bei skalierten Bauteilen wegen der geringen Breite des Spacers von nur etwa 200 nm nicht möglich. Daher verwendet man im allgemeinen Hilfsschichten, die mit selbstjustierenden Verfahren strukturiert werden, um den aktiven Basisbereich zu maskieren. Das Aufbringen und Strukturieren dieser Schichten stellt eine wesentliche Erhöhung der Prozeßkomplexität und damit der Kosten dar.

Außerdem lassen sich die Hilfsschichten im allgemeinen nicht wieder entfernen, ohne daß das aktive Basisgebiet beeinflußt wird, beispielsweise durch einen Anätzschritt. Durch die Ionenimplantation in das Linkgebiet entstehen zudem Defekte im Monosilizium, die anschließend durch Temperungen ausgeheilt werden müssen. Dabei tritt im aktiven Transistorgebiet eine unerwünschte Diffusion der Dotierstoffe auf ("transient enhanced diffusion"), die unter anderem zu einer Vergrößerung der Basisweite und damit eine Abnahme der Transitfrequenz führt.

Der zusätzliche Prozeßaufwand und die beschriebenen negativen Auswirkungen auf das aktive Bauteil führen dazu, daß die lokale Implantation sich nicht als Verfahren zur Verringerung des Linkwiderstands durchsetzen konnte und in derzeitig existierenden aktuellen Produktionstechnologien nicht zum Einsatz gelangt.

Bei der zweiten Variante, der Diffusion aus Hilfsschichten, müssen zuerst hochdotierte Schichten (beispielsweise mit Bor implantiertes Polysilizium oder Borosilikatglasschichten) auf das Emitterfenster abgeschieden werden. Anschließend werden Spacer aus diesen Schichten gebildet. Mit einem Temperungsschritt wird dann im Spacerbereich Dotierstoff aus den dotierten Hilfsschichten in das Monosilizium diffundiert. Die dotierten Spacer werden dann entfernt und die Spacer zur Emitterbasisisolation gebildet.

Auch dieses Verfahren hat gravierende Nachteile. So erfordert die Bildung der Hilfsspacer und ihre Entfernung etwa zwanzig zusätzliche Prozeßschritte. Der Temperungsschritt zur Dotierstoffausdiffusion aus den Hilfsspacern führt auch zur Diffusion der Dotierstoffe in das aktive Transistorgebiet und damit zur Veränderung der elektrischen Eigenschaften des aktiven Bauteils. Außerdem führt die Ätzung der Hilfsspacer zu einer Anätzung im aktiven Transistorgebiet. Auch dieses Verfahren hat sich in Produktionstechnologien nicht durchsetzen können.

Auf Grund der oben beschriebenen Probleme wird daher zur Zeit auf eine gezielte lokale Erhöhung der Dotierstoffkonzentration unter dem Spacer in allen bekannten Bipolartechnologien verzichtet. Die Dotierstoffkonzentration unter dem Spacer ist daher immer die gleiche wie im aktiven Transistorgebiet und wird bereits durch die Ionenimplantation zur Bildung der aktiven Basis festgelegt.

Aus der US 5,213,988 ist ein Verfahren zur Bildung eines Bipolartransistors mit selbstjustierter Basisregion bekannt. Dazu werden in einen durch eine Fotomaske definierten Bereich eines Halbleitersubstrats Dotierstoffe implantiert. Anschließend wird eine Isolationsschicht aufgebracht und mittels einer weiteren Fotomaske eine Öffnung gebildet, die den aktiven Basisbereich des Bipolartransistors definiert. Durch eine anschließende thermische Oxidation werden Dotierstoffe aus dem durch die Öffnung definierten Bereich ausdiffundiert.

Aus der US 3,974,516 ist ein Verfahren zur Herstellung eines Bipolartransistors bekannt, bei dem ein an der Oberfläche eines Halbleitersubstrats eingebrachtes Diffusionsgebiet durch eine 4-stündige thermische Behandlung bei 1200°C bis zu einem weiter in der Tiefe des Halbleitersubstrats liegenden Dotierungsgebiet ausgedehnt wird.

Bei dem aus der US 5,747,374 bekannten Verfahren zur Herstellung eines Bipolartransistors wird auf ein Halbleitersubstrat eine Polysiliziumschicht aufgebracht und in diese eine Öffnung eingebracht. Unter Verwendung von Hilfsschichten und Spacern wird eine Maske für die anschließende Dotierung des Halbleitersubstrats gebildet. Nach erfolgter Dotierung wird die Maske entfernt und an der Kante der Polysiliziumschicht ein weiterer Spacer gebildet. Mit einer abschließenden Implantation wird die Dotierung des aktiven Basisbereiches eingestellt

Es ist daher die Aufgabe der vorliegenden Erfindung, ein Verfahren zur gezielten Höherdotierung des Linkgebiets bereitzustellen, das in einfacher und kostengünstiger Weise durchzuführen ist. Diese Aufgabe löst die Erfindung durch die Bereitstellung des Verfahrens zur Herstellung benachbarter Gebiete unterschiedlicher Dotierungen in einem integrierten Halbleiter gemäß dem unabhängigen Patentanspruch 1 sowie die Verwendung des Verfahrens zur Herstellung eines Transistors gemäß dem unabhängigen Patentanspruch 10.

Weitere vorteilhafte Ausgestaltungen und Aspekte der Erfindung ergeben sich aus den abhängigen Patentansprüchen, der Beschreibung und den beigefügten Zeichnungen.

Die wesentliche Idee der vorliegenden Erfindung besteht darin, daß zuerst im gesamten Basisbereich, das heißt in der aktiven Basis und unterhalb des Spacers, die für das Linkgebiet gewünschte hohe Zielkonzentration von Dotierstoff erzeugt wird. Anschließend wird in der aktiven Basis der überschüssige Dotierstoff entfernt. Das vorliegende erfindungsgemäße Verfahren ist jedoch nicht auf die Herstellung von Transistoren beschränkt. Vielmehr ist es auf alle Halbleiterstrukturen anwendbar, bei denen zwei benachbarte Gebiete eine unterschiedliche Dotierung erhalten sollen. Der Bereich der höheren Zielkonzentration an Dotierstoff wird durch das erfindungsgemäße Verfahren mittels einer Schutzschicht abgedeckt, die eine nachfolgende Ausdiffusion des Dotierstoffs, wie in dem benachbarten Gebiet gewünscht, verhindert.

Demgemäß ist die Erfindung zunächst gerichtet auf ein Verfahren zur Herstellung zweier benachbarter Gebiete eines vorbestimmten Bereichs in einem integrierten Halbleiter, wobei ein erstes Gebiet der zwei benachbarten Gebiete eine Dotierung in niedrigerer Zielkonzentration aufweist als ein zweites Gebiet. Das erfindungsgemäße Verfahren weist folgende Schritte auf:

- Aufbringen einer Polysiliziumschicht auf einen Halbleiterrohling;

- Bilden eines Fensters in der Polysiliziumschicht, das den vorbestimmten Bereich des Halbleiterrohlings definiert;

- Dotierung des vorbestimmten Bereichs eines Halbleiterrohlings mit einem Dotierstoff bis zu einer Konzentration an Dotierstoff, die zumindest so hoch ist wie die Zielkonzentration des zweiten Gebiets;

- Ausbilden einer Schutzschicht in Form eines Spacers selbstjustiert zum Rand des Fensters, wobei der Spacer das darunter liegende Gebiet des vorbestimmten Bereichs als zweites Gebiet definiert; und

- Ausdiffundieren des Dotierstoffs aus dem vom Spacer freibleibenden ersten Gebiet bis zu einer Konzentration an Dotierstoff, die der Zielkonzentration des ersten Gebiets entspricht.

Unter einer Schutzschicht ist hierbei jede auf das zweite Gebiet aufbringbare Schicht zu verstehen, die verhindert, daß bei der anschließenden Ausdiffusion des Dotierstoffs aus dem zweiten Gebiet Dotierstoff ausdiffundieren kann.

Unter einem Gebiet im Sinne des Patentanspruchs ist eine umgrenzte Region in einem Halbleiter zu verstehen, welche aus einem homogenen Material und einer lateral gleichmäßigen Dotierstoffkonzentration besteht. In vertikaler Richtung, das heißt in den Halbleiter hinein, ändert sich je nach verwendetem Verfahren die Dotierung.

Unter einem Bereich im Sinne der vorliegenden Erfindung ist eine umgrenzte Region zu verstehen, die ein oder mehrere Gebiete wie vorstehend definiert umfaßt.

Unter einem Halbleiterrohling wird eine durch einen Halbleiterprozeß hergestellte Anordnung von Strukturen verstanden, die sich noch im Prozeß der Fertigstellung befinden, also noch nicht voll funktionsfähig sind.

Um eine Wegätzung zusätzlich aufgebrachter Schichten, wie im Stand der Technik bekannt, zu vermeiden, erfolgt die Dotierung vorzugsweise durch eine Dotierstoffimplantation, bei der die Dotierstoffe als Ionen in einem elektrischen Feld beschleunigt und auf das Substratmaterial gelenkt werden. Dieses Verfahren hat den Vorteil, die Konzentration und die Lage der dotierten Bereiche im, Kristallgefüge des dotierten Gebiets sehr exakt kontrollierbar zu machen.

Um möglicherweise aufgetretene Implantationsschäden im vorbestimmten dotierten Bereich auszuheilen, kann nach der Dotierung und vor dem Aufbringen der Schutzschicht eine Temperung des vorbestimmten Bereichs erfolgen, also eine gezielte Erhöhung der Temperatur. Da es hierbei zu einer Ausdiffusion des Dotierstoffs kommt, wird in einem solchen Fall bevorzugt die Implantation an Dotierstoff bis zu einer Konzentration durchgeführt, die über der Zielkonzentration im zweiten Gebiet liegt. Vorzugsweise wird daher gewünscht, daß ein durch die Temperung verursachtes Ausdiffundieren bis zu einer Konzentration an Dotierstoff erfolgt, die dann der Zielkonzentration des zweiten Gebiets entspricht.

Der hier zum Einsatz kommende Dotierstoff kann aus dem gesamten bekannten Spektrum von zur Verfügung stehenden Dotierstoffen ausgewählt werden, vorzugsweise beispielsweise aus Bor, Aluminium, Gallium, Indium, Phosphor, Arsen und Antimon. Ein üblicher Stoff bei heutigen Dotierungen ist Bor, welches den Vorteil hat, die höchste elektrische Aktivierbarkeit (d.h. Konzentration an in das Siliziumgitter eingebauter Atome) aufzuweisen.

Das Ausdiffundieren des Dotierstoffs aus dem ersten Gebiet, also nach dem Aufbringen der Schutzschicht, erfolgt vorzugsweise ebenfalls durch eine Temperung.

Wie bereits oben erläutert, kann das erfindungsgemäße Verfahren zur Herstellung verschiedenster benachbarter Gebiete eingesetzt werden. Dem muß auch die Schutzschicht angepaßt werden. Bei einem bevorzugten Verfahren, nämlich der Herstellung von integrierten Transistoren, bei dem das erfindungsgemäße Verfahren zur Herstellung des Basisgebiets des Transistors dient, ist diese Schutzschicht ein selbst justierender Spacer, der den Emitterbereich von seitlich verlaufenden Basiskontakten trennt.

In einer bevorzugten Ausführungsform ist, wie erläutert, der vorbestimmte Bereich der Basisbereich eines Transistors. Somit ist das erste Gebiet das Basisgebiet des aktiven Transistors und das zweite Gebiet kann das Linkgebiet zwischen Basisgebiet und Polysiliziumbahn sein.

Die Erfindung führt weiterhin zu einem Transistor mit Emitter, Kollektor und Basis und einen den Emitter umgebenden Spacer, bei dem der Basisbereich unterhalb des Spacers höher dotiert ist als der Basisbereich unter dem Emitter und der herstellbar ist nach dem erfindungsgemäßen Verfahren.

Ein solcher Transistor zeichnet sich dadurch aus, daß die Basis Unterschiede in der Dotierung zwischen Linkgebiet und aktivem Basisgebiet aufweist und einerseits durch die verwendete Implantationstechnik eine höhere und genau definierte Implantation im Linkgebiet erfolgen kann, andererseits durch die nicht mehr vorhandene unerwünschte Diffusion der Dotierstoffe die Basisweite exakt eingehalten und zudem klein gehalten werden kann. Ein Transistor mit solchen wünschenswerten Eigenschaften ist bislang im Stand der Technik nicht bekannt. Insbesondere kann eine Dotierung im zweiten Gebiet, d.h. im Linkgebiet, bis zu einer Konzentration von über $2 \times 10^{20}$ Teilchen/cm$^3$ erreicht werden. Vorzugsweise liegt die Konzentration zwischen $5 \times 10^{19}$ und $2 \times 10^{20}$ Teilchen/cm$^3$, besonders bevorzugt bei $10^{19}$ bis $2 \times 10^{20}$ Teilchen/cm$^3$, beispielsweise bei $10^{20}$ bis $2 \times 10^{20}$. Demgegenüber weist das erste Gebiet, im vorliegenden Fall also das aktive Basisgebiet, eine Konzentration von typischerweise $5 \times 10^{19}$ Teilchen/cm$^3$ auf. Es versteht sich, daß die angegebenen Werte, wenn auch hier in Bezug auf einen Transistor genannt, auch bei anderen Halbleiterstrukturen, die nach dem erfindungsgemäßen Verfahren hergestellt werden, erreicht werden können.

Die Erfindung ist schließlich auch gerichtet auf die Verwendung des Verfahrens zur Herstellung eines Transistors, bei dem der Basisbereich unterhalb des den Emitter umgebenden Spacers höher dotiert ist als der Basisbereich unter dem Emitter.

Das erfindungsgemäße Verfahren zur Herstellung von Halbleiterstrukturen weist eine Reihe von Vorteilen auf. Gegenüber dem derzeitig im Einsatz befindlichen Verfahren, das nicht eine selektive Dotierung benachbarter Gebiete ermöglicht, kommt es zu praktisch keiner Erhöhung der Prozeßkomplexität und damit auch zu keiner Erhöhung der Kosten. Es wird lediglich die Temperung zum Ausheilen der Kristallschäden nach der Implantation in zwei Schritte aufgeteilt, sofern ein Temperungsschritt nach der Implantation nötig ist. Somit werden für das erfindungsgemäße Verfahren keine neuen Anlagen oder neue Materialien benötigt.

Weiterhin sind keine zusätzlichen Linkimplantationen nötig, die zu einer erhöhten Diffusion im aktiven Transistorgebiet führen. Das Verfahren ist zudem selbstjustierend, da der Spacer selbst als Diffusionsbarriere verwendet wird, und daher die zusätzliche Dotierung genau im unter dem Spacer liegenden Linkgebiet erzielt wird. Schließlich ist das Verfahren universell einsetzbar, da es nicht nur auf Transistoren, sondern auch auf andere Strukturen in Halbleitern anwendbar ist und beispielsweise bezüglich Transistoren alle derzeitig selbstjustierenden Siliziumbipolartransistoren nach dem erfindungsgemäßen Verfahren hergestellt werden können.

Im folgenden soll die Erfindung an Hand eines konkreten Beispiels erläutert werden, wobei auf die Abbildungen Bezug genommen werden wird, in denen folgendes dargestellt ist:

Figur 1    zeigt wie oben beschrieben ein Verfahren zur Herstellung von Transistoren, wie es im Stand der Technik bekannt ist;

Figur 2    beschreibt das erfindungsgemäße Verfahren;

Figur 3    zeigt Konzentrationen an Dotierstoff nach den verschiedenen Verfahrensschritten; und

Figur 4    zeigt Gatterverzögerungszeiten von erfindungsgemäß hergestellten Transistoren.

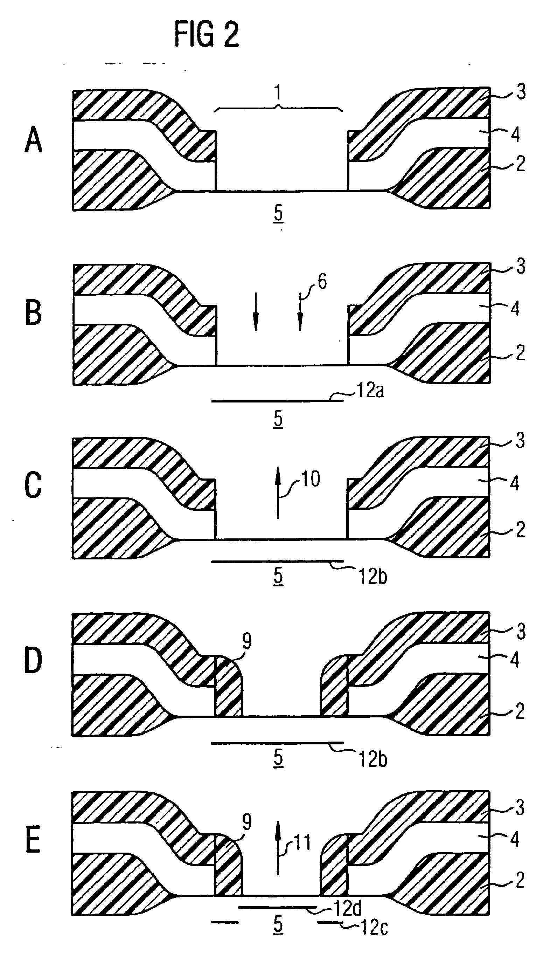

Figur 2A entspricht der Darstellung der Figur 1A, wobei gleiche Strukturen mit gleichen Bezugszeichen versehen sind. Es erfolgt eine Implantation an Dotierstoff, wie durch die Pfeile 6 gekennzeichnet ist (siehe Figur 2B). Diese Implantation führt zu einer relativ hohen Konzentration an Dotierstoff 12a innerhalb des Transistoruntergrundes 5. Bei der in Figur 2 gezeigten konkreten Ausführungsform der Erfindung schließt sich ein Temperungsschritt an, der in Figur 2C gezeigt wird und bei dem es zu einer Ausdiffusion, dargestellt durch Pfeil 10, kommt, die zu einer Erniedrigung der Konzentration an Dotierstoff (12b) führt.

Wie in Figur 2D gezeigt, wird im Anschluß an den Temperungsschritt der Spacer 9 im Emitterfenster 8 gelagert.

Der in Figur 2E gezeigte zweite Temperungsschritt (Pfeil 11) führt nunmehr zu einer unterschiedlichen Zielkonzentration an Dotierstoffen im Transistorbereich 5, nämlich zum einen eine niedrigere Konzentration 12d an Dotierstoff im eigentlichen aktiven Bereich der Basis sowie einer höheren Dotierstoffkonzentration 12c im Linkbereich unterhalb des Spacers 9. Im Linkgebiet wird der Dotierstoff durch den Spacer eingeschlossen. Insgesamt ergibt sich hiermit ein Transistor, bei dem die Dotierung im Spacerbereich höher ist als im aktiven Basisbereich. Der Fachmann kann das erfindungsgemäße Verfahren auch zur Herstellung anderer Strukturen eines Halbleiters als für Transistoren einsetzen.

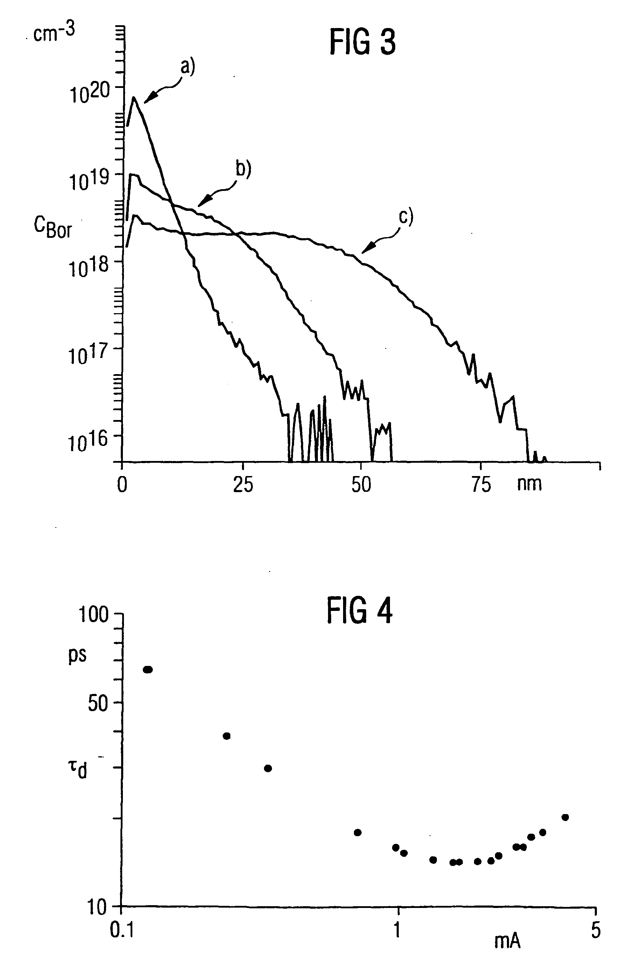

Figur 3 zeigt experimentelle Ergebnisse an ganzflächigen Siliziumscheiben, bei denen das Verfahren zur Basisdotierung simuliert wurde. Hierbei wurden mit SIMS (Sekundärionen-Massenspektrometrie) gemessene Dotierstoffprofile aufgetragen. Auf der Abszisse ist die Eindringtiefe des Dotierstoffs in Nanometern angegebenen, auf der Ordinate die Konzentration des Dotierstoffs, hier Bor, in Teilchen/cm$^3$.

Kurve a) zeigt die Basisdotierung unmittelbar nach der Implantation. Die Dotierung nach der ersten Temperung zum Ausheilen der Kristalldefekte wird durch Kurve b) veranschaulicht. Hier zeigt sich bereits ein erstes Absinken der Dotierstoffkonzentration unmittelbar an der Oberfläche um einen Faktor von 10. Diese Dotierstoffkonzentrationen bleiben unterhalb der Schutzschicht erhalten, da sie von dieser eingeschlossen und damit konserviert werden.

Die Kurve c) ergibt sich nach einer zweiten Temperung und diese stellt somit die Dotierung im ersten, niedriger dotierten Gebiet, beispielsweise im aktiven Transistorgebiet, dar.

Nach dem erfindungsgemäßen Verfahren hergestellte Transistoren sind voll funktionsfähig. Zur Abschätzung der Transistorperformance wurden Gatterverzögerungszeiten von CML-Ringoszillatoren (Current Mode Logic-Ringoszillatoren) gemessen. Die Ergebnisse dieser Messungen sind in Figur 4 dargestellt. Auf der Abszisse sind die Schaltströme dargestellt, während auf der Ordinate die Gatterverzögerungszeiten in Picosekunden dargestellt sind. Wie aus der Figur 4 ersichtlich, ergeben sich minimale Verzögerungszeiten von unter 15 psec, während bei herkömmlich hergestellten Transistoren (wie beispielsweise bei dem Siemens Transistor B6HF) Gatterverzögerungszeiten von 25 psec üblich sind.

**Patentansprüche**

1. Verfahren zur Herstellung zweier benachbarter Gebiete eines vorbestimmten Bereichs in einem integrierten Halbleiter, wobei ein erstes Gebiet der zwei benachbarten Gebiete eine Dotierung in niedrigerer Zielkonzentration aufweist als ein zweites Gebiet, folgende Schritte aufweisend:

- Aufbringen einer Polysiliziumschicht (4) auf einen Halbleiterrohling;
- Bilden eines Fensters (1) in der Polysiliziumschicht (4), das den vorbestimmten Bereich (5) des Halbleiterrohlings definiert;
- Dotierung des vorbestimmten Bereichs (5) des Halbleiterrohlings mit einem Dotierstoff bis zu einer Konzentration an Dotierstoff (12b, 12c), die zumindest so hoch ist wie die Zielkonzentration des zweiten Gebiets;
- Ausbilden eines Spacers (9) selbstjustiert zum Rand des Fensters (1), wobei der Spacer (9) das darunter liegende Gebiet des vorbestimmten Bereichs (5) als zweites Gebiet definiert; und
- Ausdiffundieren des Dotierstoffes aus dem vom Spacer (9) freibleibenden ersten Gebiet bis zu einer Konzentration (12a) an Dotierstoff, die der Zielkonzentration des ersten Gebiets entspricht.

2. Verfahren nach Anspruch 1, **dadurch gekennzeichnet, daß** die Dotierung durch eine Dotierstoffimplantation erfolgt.

3. Verfahren nach Anspruch 1 oder 2, **dadurch gekennzeichnet, daß** nach der Dotierung und vor der Ausbildung des Spacers eine Temperung des vorbestimmten Bereichs erfolgt.

4. Verfahren nach Anspruch 3, **dadurch gekennzeichnet, daß** ein durch die Temperung erfolgtes Ausdiffundieren bis zu einer Konzentration an Dotierstoff erfolgt, die der Zielkonzentration des zweiten Gebiets entspricht.

5. Verfahren nach einem der Ansprüche 1 bis 4, **dadurch gekennzeichnet, daß** der Dotierstoff ausgewählt ist aus Bor, Aluminium, Gallium, Indium, Phosphor, Arsen und Antimon.

6. Verfahren nach einem der Ansprüche 1 bis 5, **dadurch gekennzeichnet, daß** das Ausdiffundieren durch eine Temperung erfolgt.

7. Verfahren nach einem der Ansprüche 1 bis 6, **dadurch gekennzeichnet, daß** der vorbestimmte Bereich der Basisbereich eines Transistors ist.

8. Verfahren nach Anspruch 7, **dadurch gekennzeichnet, daß** das erste Gebiet das Basisgebiet des aktiven Transistors ist.

9. Verfahren nach **dadurch** Anspruch 7 oder 8, **dadurch gekennzeichnet, daß** das zweite Gebiet das Link-Gebiet zwischen Basisgebiet und Polysiliziumbahn ist.

10. Verwendung des Verfahrens nach einem der Ansprüche 1 bis 9 zur Herstellung eines integrierten Transitors, bei dem der Basisbereich unterhalb des den Emitter umgebenden Spacers höher dotiert ist als der Basisbereich unter dem Emitter.

**Claims**

1. Process for the production of two adjacent regions of a predetermined area in an integrated semiconductor, a first region of the two adjacent regions having a doping at a lower target concentration than a second region, having the following steps:

   - applying a polysilicon layer (4) to a semiconductor blank;
   - forming a window (1) in the polysilicon layer (4), said window defining the predetermined area (5) of the semiconductor blank;
   - doping the predetermined area (5) of the semiconductor blank with a dopant as far as a concentration of dopant (12b, 12c) which is at least as high as the target concentration of the second region;
   - forming a spacer (9) in a self-aligned manner as far as the edge of the window (1), the spacer (9) defining the underlying region of the predetermined area (5) as the second region; and
   - diffusing the dopant outward from the first region, remaining free from the spacer (9), as far as a concentration (12a) of dopant which corresponds to the target concentration of the first region.

2. Process according to Claim 1, **characterized in that** the doping is carried out by means of dopant implantation.

3. Process according to Claim 1 or 2, **characterized in that** after the doping and before the formation of the spacer, tempering of the predetermined area is carried out.

4. Process according to Claim 3, **characterized in that** outward diffusion carried out by tempering takes place as far as a concentration of dopant which corresponds to the target concentration of the second region.

5. Process according to one of Claims 1 to 4, **characterized in that** the dopant is selected from boron, aluminum, gallium, indium, phosphorus, arsenic and antimony.

6. Process according to one of Claims 1 to 5, **characterized in that** the outward diffusion is carried out by means of tempering.

7. Process according to one of Claims 1 to 6, **characterized in that** the predetermined area is the base area of a transistor.

8. Process according to Claim 7, **characterized in that** the first region is the base region of the active transistor.

9. Process according to Claim 7 or 8, **characterized in that** the second region is the link region between base region and polysilicon track.

10. Use of the method according to one of Claims 1 to 9, for the production of an integrated transistor, in which the base area underneath the spacer surrounding the emitter is more highly doped than the base area under the emitter.

**Revendications**

1. Procédé de production de deux zones voisines d'un domaine déterminé à l'avance dans un semi-conducteur intégré, dans lequel une première zone des deux zones voisines a un dopage en une concentration visée plus petite qu'une deuxième zone, comprenant les stades suivants :

    - on dépose une couche (4) de polysilicium sur une ébauche de semi-conducteur,
    - on forme une fenêtre (1) dans la couche (4) de polysilicium, qui définit le domaine (5) déterminé à l'avance de l'ébauche de semi-conducteur,
    - on dope le domaine (5) déterminé à l'avance de l'ébauche de semi-conducteur par une substance de dopage jusqu'à une concentration en substance (12b, 12c) de dopage, qui est au moins aussi grande que la concentration visée de la deuxième zone,
    - on forme un espaceur (9) à auto-alignement par rapport au bord de la fenêtre (1), l'espaceur (9) définissant en tant que deuxième zone la zone sous-jacente du domaine (5) déterminé à l'avance ; et
    - on fait diffuser la substance de dopage de la première zone restant libre de l'espaceur (9) jusqu'à une concentration (12a) en substance de dopage, qui correspond à la concentration visée de la première zone.

2. Procédé suivant la revendication 1, **caractérisé en ce que** l'on effectue le dopage par une implantation de substance de dopage.

3. Procédé suivant la revendication 1 ou 2, **caractérisé en ce que,** après le dopage et avant la formation de l'espaceur, on effectue un traitement thermique du domaine déterminé à l'avance.

4. Procédé suivant la revendication 3, **caractérisé en ce que** l'on effectue une diffusion effectuée par le traitement thermique jusqu'à une concentration de la substance de dopage qui correspond à la concentration visée de la deuxième zone.

5. Procédé suivant l'une des revendications 1 à 4, **caractérisé en ce que** l'on choisit la substance de dopage parmi le bore, l'aluminium, le gallium, l'indium, le phosphore, l'arsenic et l'antimoine.

6. Procédé suivant l'une des revendications 1 à 5, **caractérisé en ce que** l'on effectue la diffusion par un traitement thermique.

7. Procédé suivant l'une des revendications 1 à 6, **caractérisé en ce que** le domaine déterminé à l'avance est le domaine de base d'un transistor.

8. Procédé suivant la revendication 7, **caractérisé en ce que** la première zone est la zone de base du transistor actif.

9.  Procédé suivant la revendication 7 ou 8, **caractérisé en ce que** la deuxième zone est la zone de liaison entre la zone de base et la piste en polysilicium.

10. Utilisation du procédé suivant l'une des revendications 1 à 9 pour la production d'un transistor intégré, dans lequel le domaine de base, en dessous de l'espaceur entourant l'émetteur, est plus dopé que le domaine de base sous l'émetteur.

# FIG 1

## Stand der Technik

# FIG 2

A

B

C

D

E

FIG 3

FIG 4

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5213988 A
- US 3974516 A
- US 5747374 A